# EUROPÄISCHE PATENTANMELDUNG

(11) **EP 1 455 426 A2**
(43) Veröffentlichungstag der Anmeldung: **08.09.2004**
(21) Anmeldenummer: 04002707.0
(22) Anmeldetag: 06.02.2004
(51) Int. Cl.: H01S 5/022, H01S 5/024

(54) **Lasermodul**

(30) Priorität: 21.02.2003 DE 20302873 U
(71) Anmelder: Harting Electro-Optics GmbH & Co. KG., 32339 Espelkamp (DE)
(72) Erfinder: Krause, Jens, Dr.-Ing., 32369 Rahden (DE)
(74) Vertreter: Sties, Jochen, Dipl.-Ing.

(57) **Zusammenfassung**

Die Erfindung betrifft ein Lasermodul mit einem Trägerkörper (10), der auf einer Leiterplatte (5) montiert werden kann, einer transparenten Scheibe (28), die in dem Trägerkörper (10) aufgenommen ist, einem Laserchip (22), der in dem Trägerkörper (10) so angebracht ist, daß seine Austrittsfläche der Scheibe (28) zugewandt ist, einem Leiterelement (12, 44, 54), das zum Kontaktieren des Laserchips dient und selbst Anschlußkontakte (20) aufweist, die mit Leiterbahnen der Leiterplatte (5) verbunden werden können, und einer Vergußmasse (34), die den Raum zwischen der Scheibe (28) und der Austrittsfläche des Laserchips (22) ausfüllt.

## Beschreibung

Die Erfindung betrifft ein Lasermodul. Dieses Lasermodul ist insbesondere zur Verwendung bei einem Abstandsmeßgerät in einem Kraftfahrzeug vorgesehen, bei dem mittels eines Laserstrahls oder mehrerer Laserstrahlen beispielsweise der Abstand zu einem vorausfahrenden Fahrzeug ermittelt werden kann.

Aus der vorgesehenen Verwendung des Lasermoduls bei einem Kraftfahrzeug ergeben sich besondere Anforderungen. Zum einen muß das Lasermodul über einen großen Temperaturbereich zuverlässig arbeiten. Zum anderen muß es sehr robust sein, insbesondere hinsichtlich seiner optischen Oberfläche. Um eine präzise Ausrichtung der vom Lasermodul ausgesandten Laserstrahlen zu gewährleisten, sind enge Toleranzen einzuhalten. Schließlich ist es wünschenswert, daß der Laser senkrecht zu einer Leiterplatte abstrahlt, auf der er angebracht ist, und daß die Kontaktierung des Lasermoduls auf der Leiterplatte in SMT-Technik erfolgt.

Diese Anforderungen werden von einem erfindungsgemäßen Lasermodul erfüllt. Es enthält einen Trägerkörper, der auf einer Leiterplatte montiert werden kann, eine transparente Scheibe, die in dem Trägerkörper aufgenommen ist, einen Laserchip, der in dem Trägerkörper so angebracht ist, daß seine Austrittsfläche der Scheibe zugewandt ist, ein Leiterelement, das zum Kontaktieren des Laserchips dient und selbst Anschlußkontakte aufweist, die mit Leiterbahnen der Leiterplatte verbunden werden können, und eine Vergußmasse, die den Raum zwischen der Scheibe und der Austrittsfläche des Laserchips ausfüllt. Die transparente Scheibe, die insbesondere aus Glas bestehen kann, bildet eine robuste optische Oberfläche, die beständig gegen Umwelteinflüsse ist. Die hinter der Scheibe vorgesehene Vergußmasse, die vorzugsweise aus Silikon besteht, dient zum einen der guten optischen Kopplung zwischen der Austrittsfläche des Laserchips und der transparenten Scheibe und zum anderen zur mechanischen Entkopplung zwischen der Scheibe und dem Laserchip; sollte die Scheibe in Schwingungen geraten, werden diese von der Vergußmasse nicht auf den Laserchip übertragen, da die Vergußmasse eine ausreichend hohe Dämpfung und Elastizität aufweist.

Vorteilhafte Ausgestaltungen der Erfindung ergeben sich aus den Unteransprüchen.

Die Erfindung wird nachfolgend anhand verschiedener Ausführungsformen beschrieben, die in den beigefügten Zeichnungen dargestellt sind. In diesen zeigen:
- die Figuren 1 bis 6 ein Lasermodul gemäß einer ersten Ausführungsform der Erfindung in mehreren Schritten während der Montage;
- die Figuren 7 bis 11 ein Lasermodul gemäß einer zweiten Ausführungsform der Erfindung in mehreren Schritten während der Montage; und
- die Figuren 12 bis 15 ein Lasermodul gemäß einer dritten Ausführungsform der Erfindung in mehreren Schritten während der Montage.

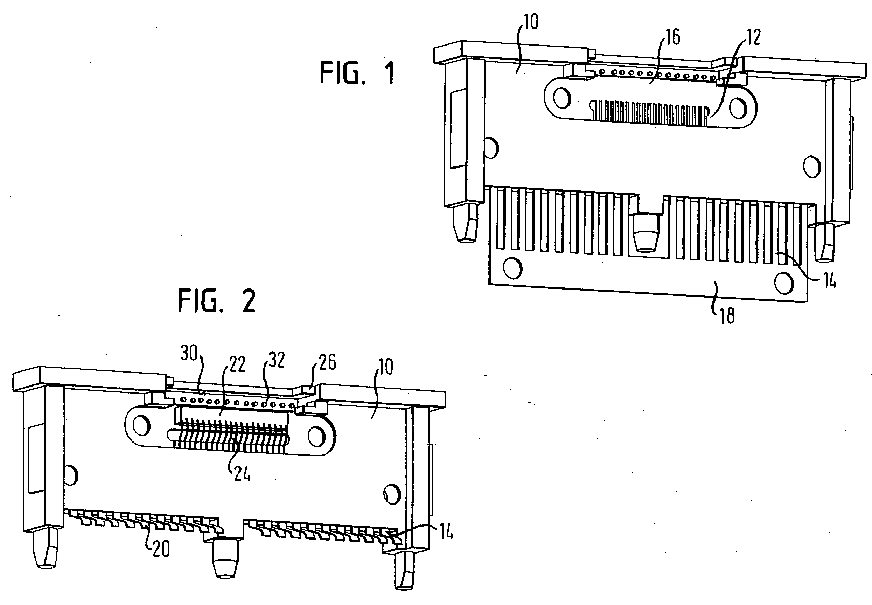

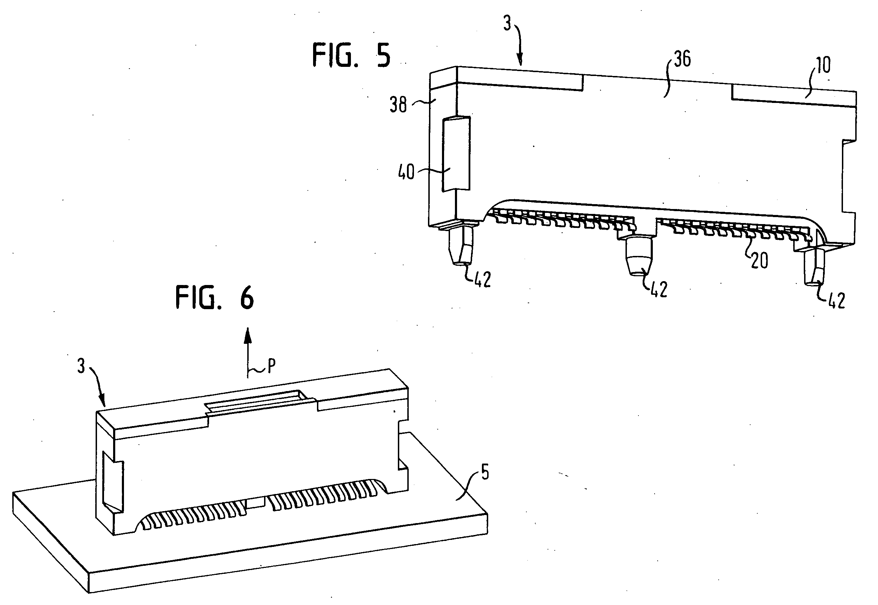

In den Figuren 1 bis 6 ist ein Lasermodul 3 gemäß einer ersten Ausführungsform gezeigt. Es ist dafür vorgesehen, auf einer Leiterplatte 5 (siehe Figur 6) montiert zu werden, so daß ein oder mehrere Laserstrahlen senkrecht zur Oberfläche der Leiterplatte 5, also in der Richtung des Pfeils P von Figur 6, abgegeben werden können.

Das Lasermodul weist einen Trägerkörper 10 auf (siehe Figur 1), der ein Spritzgußteil aus Kunststoff ist. Eingespritzt in den Trägerkörper 10 ist ein Leiterelement, das bei der ersten Ausführungsform als Leadframe 12 ausgeführt ist, der zur späteren Anbringung und Kontaktierung eines Laserchips dient. Zu diesem Zweck weist der Leadframe 12 mehrere Kontaktstege 14 auf, die im Ausgangszustand, wie er in Figur 1 gezeigt ist, einerseits mit einem als Montageabschnitt 16 dienenden Bereich des Leadframes und andererseits mit einem Verbindungssteg 18 verbunden sind, der später abgeschnitten wird, sobald die Kontaktstege 14 im Material des Trägerkörpers 10 aufgenommen sind. Dann kann auch die Verbindung zwischen den Kontaktstegen 14 und dem Montageabschnitt 16 getrennt werden. Dieser Zustand ist in Figur 2 zu sehen. Außerdem ist in Figur 2 zu erkennen, daß die Kontaktstege 14 auf der Seite des Trägerkörpers 10, die später der Leiterplatte 5 zugewandt ist, abgebogen sind, so daß Anschlußkontakte 20 gebildet sind. Diese erstrecken sich schräg zur Oberfläche der Leiterplatte 5.

Wie außerdem in Figur 2 zu sehen ist, ist auf den Montageabschnitt 16 des Leadframes 12 ein Laserchip 22 aufgesetzt, der je nach Anforderungen einen oder mehrere Laser aufweisen kann. Der Montageabschnitt 16 dient, da er aus Metall besteht, zusätzlich als Kühlkörper für den Laserchip. Zur Kontaktierung der Kontaktstege 14 werden Bonddrähte 24 verwendet.

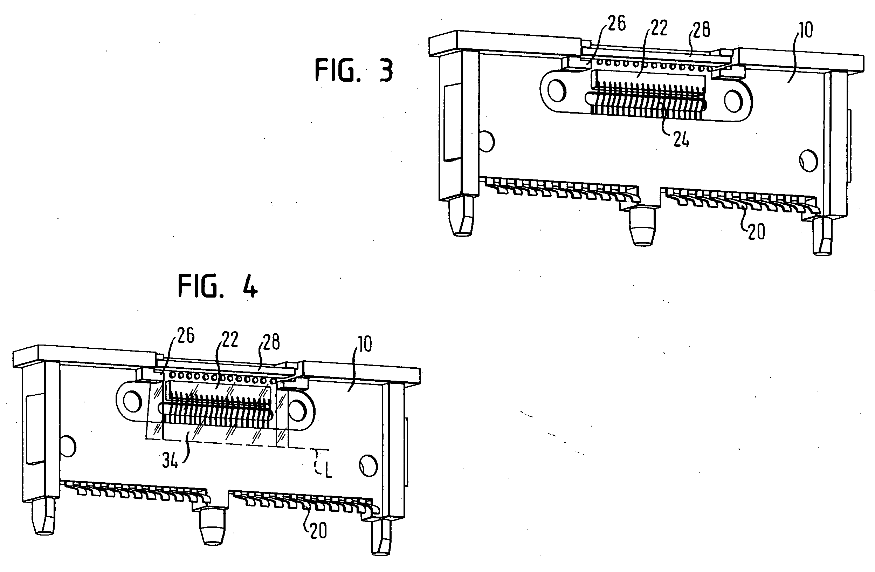

Der Trägerkörper 10 ist auf seiner dem Laserchip 22 gegenüberliegenden Außenseite mit einem Rahmen 26 versehen, in welchem eine transparente Glasscheibe 28 (siehe Figur 3) aufgenommen werden kann. Der Rahmen 26 umschließt die Glasscheibe 28 an ihren beiden kurzen Querseiten und an einer ihrer Längsseiten. Er ist gebildet durch eine durchgehende Anlagefläche 30, die auf der der Außenseite des Trägerkörpers 10 zugewandten Seite angeordnet ist, und mehrere Andruckvorsprünge 32 auf der dem Inneren des Trägerkörpers 10 zugewandten Seite. Die Andruckvorsprünge 32 sind aufeinanderfolgend angeordnet, so daß ein zahnstangenartiges Profil gebildet ist (siehe insbesondere Figur 2). Der Rahmen 26 ist so dimensioniert, daß die Glasscheibe 28 spielfrei im Rahmen 26 aufgenommen ist. Die Andruckvorsprünge 32 sind dabei, da sie an der Glasscheibe 28 theoretisch nur mit Linienberührung angreifen, so nachgiebig, daß einerseits ein Preßsitz gebildet ist, der die Scheibe zuverlässig fest hält, andererseits jedoch derart elastisch, daß die Scheibe mit geringem Aufwand eingeschoben werden kann.

Nachdem die Glasscheibe 28 im Rahmen 26 am Trägerkörper 10 montiert ist, wird eine Vergußmasse 34 (siehe Figur 4) aufgebracht. Diese besteht aus Silikon, das den Raum zwischen den optischen Austrittsflächen des Laserchips 22 und der Glasscheibe 28 vollständig ausfüllt, so daß dort eine gute optische Kopplung erzielt wird. Zum Einfüllen der Vergußmasse 34 wird der Trägerkörper 10 schräg gehalten, so daß der in Figur 4 sichtbare Seitenrand der Glasscheibe 28 und die in Figur 4 eingezeichnete, gedachte Linie L in einer waagrecht liegenden Ebene angeordnet sind. Dann wird die Vergußmasse 34 in den Raum zwischen der Glasplatte 28 und dem Laserchip 22 eingefüllt, so daß sie sich dort frei ausbreiten kann. Die Menge der Vergußmasse wird dadurch bestimmt, daß die Vergußmasse bis zum Erreichen einer bestimmten Füllhöhe eingefüllt wird. Diese Füllhöhe ist so bemessen, daß die Vergußmasse 34 bis zu dem in Figur 4 sichtbaren Längsrand der Glasscheibe 28 reicht, der bei schräg angeordnetem Trägerkörper 10 einen Oberrand des zur Aufnahme der Vergußmasse 34 vorgesehenen Raumes bildet, sowie auf dem Trägerkörper 10 im Bereich der Linie L ausläuft. Anders ausgedrückt bildet die Vergußmasse 34 einen Keil, der an der Linie L beginnt und mit maximaler Dicke an der Scheibe 28 endet.

Die Vergußmasse 34 ist hinsichtlich ihrer Eigenschaften so gewählt, daß sie die Scheibe 28 verklebt. Dies verhindert, daß Schmutzpartikel oder Feuchtigkeit in den Raum zwischen der Glasscheibe 28 und dem Laserchip eindringen können. Außerdem hat die Vergußmasse 34 eine solche Eigendämpfung und Eigenelastizität, daß eventuelle Schwingungen der Glasscheibe 28 nicht auf den Laserchip 22 übertragen werden.

Nach dem Aufbringen der Vergußmasse 34 wird auf die Seite des Trägerkörpers 10, auf der die Glasscheibe 28 und der Laserchip 22 montiert sind, eine Abdeckung 36 (siehe Figur 5) aufgesetzt, die zwei Seitenteile 38 aufweist, die hinter Rasthaken 40 einrasten, die am Trägerkörper 10 ausgebildet sind. Das Lasermodul 3 ist nun fertig montiert und kann auf der Leiterplatte 5 angebracht werden. Zur präzisen Positionierung des Trägerkörpers 10 und damit des Lasermoduls sind am Trägerkörper 10 insgesamt drei Positionierstifte 42 vorgesehen, die in entsprechende Positionieröffnungen in der Leiterplatte eingesetzt werden können. Die schräg verlaufenden Anschlußkontakte 20 ermöglichen es, mit zugehörigen Leiterbahnen in der Leiterplatte 5 in SMT-Technik verbunden zu werden, wobei die jeweiligen Lötstellen optisch von der Seite des Trägerkörpers 10 aus überprüft werden können, die in der Darstellung von Figur 6 nicht sichtbar ist, also von der Rückseite des Trägerkörpers aus.

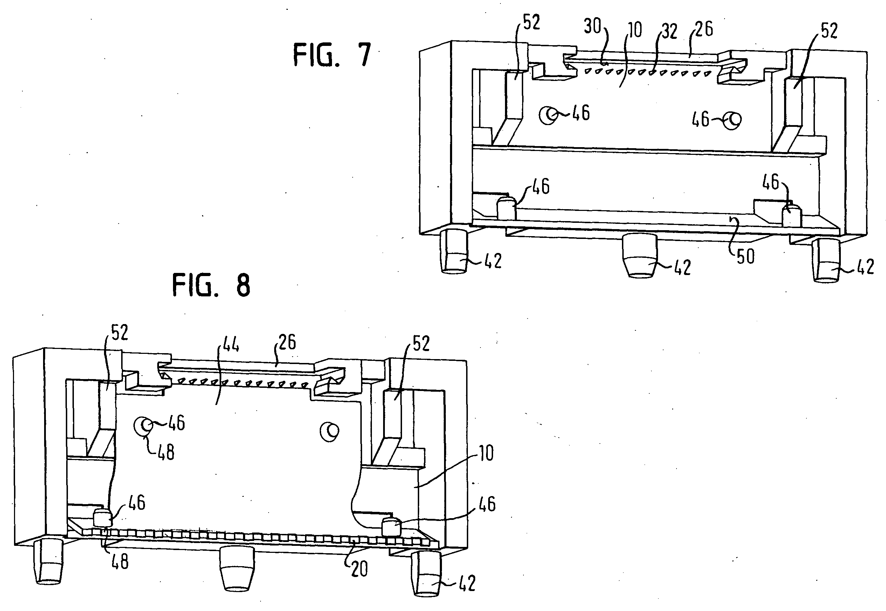

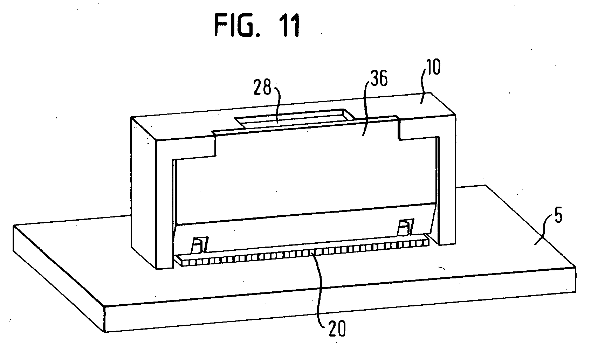

In den Figuren 5 bis 11 ist ein Lasermodul gemäß einer zweiten Ausführungsform gezeigt. Für die von der ersten Ausführungsform bekannten Bauteile werden dieselben Bezugszeichen verwendet, und es wird insoweit auf die obigen Erläuterungen verwiesen.

Der wesentlichste Unterschied zwischen der ersten und der zweiten Ausführungsform besteht darin, daß als Leiterelement zur Kontaktierung des Laserchips 22 bei der zweiten Ausführungsform eine flexible Leiterfolie 44 verwendet wird. Auch bei der zweiten Ausführungsform ist der Laserchip 22 unmittelbar auf dem Leiterelement angeordnet. Zur präzisen Positionierung der flexiblen Leiterfolie 44 weist der Trägerkörper 10 mehrere Positioniemasen 46 auf, die in Positionieraussparungen 48 eingreifen, die in der flexiblen Leiterfolie 44 gebildet sind.

Auch die flexible Leiterfolie 44 weist Anschlußkontakte 20 auf, die schräg zur Oberfläche der Leiterplatte ausgerichtet sind. Zu diesem Zweck wird der Randabschnitt der Leiterfolie 44 durch eine schräg angeordnete Anlagefläche 50 am Trägerkörper 10 entsprechend geführt.

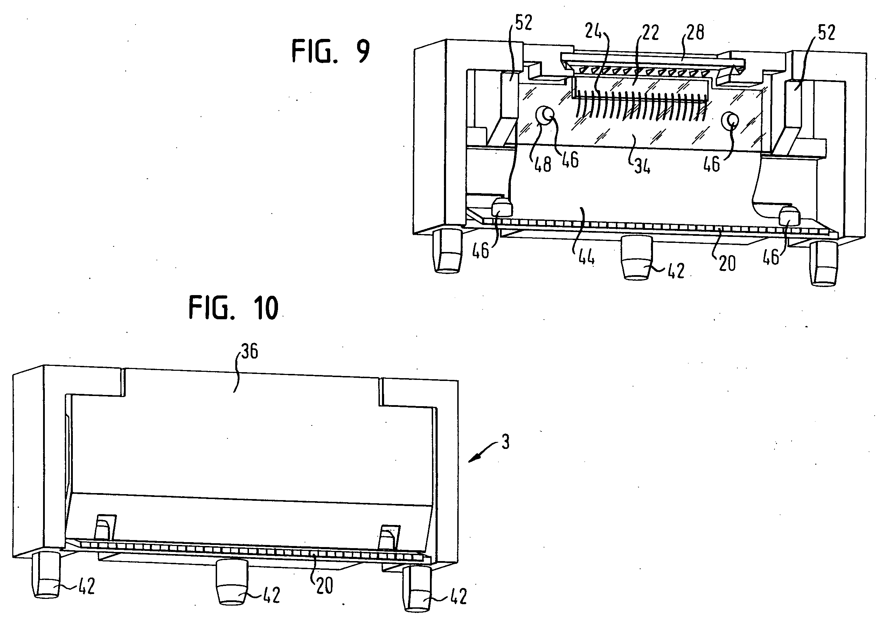

Auch bei der zweiten Ausführungsform wird der Trägerkörper 10 schräg ausgerichtet, um die Vergußmasse 34 einzufüllen. Im Unterschied zur ersten Ausführungsform ist der zur Aufnahme der Vergußmasse 34 bestimmte Raum nicht nur durch die Glasscheibe 28 und den eigentlichen Körper des Trägerkörpers 10 begrenzt, sondern es sind zusätzlich zwei Seitenstege 52 vorgesehen, die den Aufnahmeraum seitlich begrenzen. An dem in Figur 9 rechts angeordneten Seitensteg 52 läßt sich gut der Verlauf der Dicke der Vergußmasse 34 erkennen, der von der Leiterplatte weg und hin zur Scheibe 28 zunimmt.

Nach dem Einfüllen der Vergußmasse 34 wird auch bei der zweiten Ausführungsform eine Abdeckung 36 aufgebracht. Die Abdeckung 36 rastet hinter den Positioniernasen 46 ein, die auf der Anlagefläche 50 angeordnet sind. Außerdem stützt sich die Abdeckung 36 auf den Seitenstegen 52 ab.

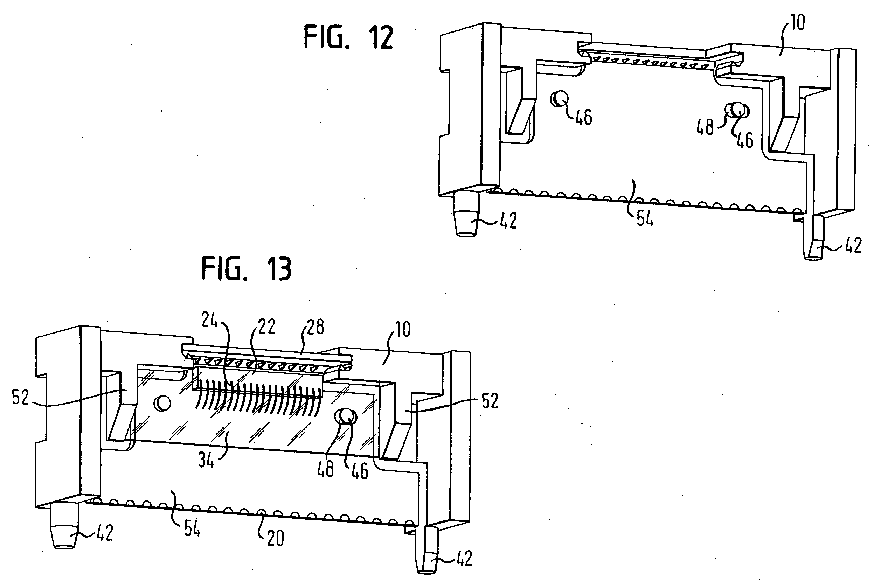

In den Figuren 12 bis 15 ist ein Lasermodul gemäß einer dritten Ausführungsform gezeigt. Für die von den vorangegangenen Ausführungsformen bekannten Bauteile werden dieselben Bezugszeichen verwendet, und es wird insoweit auf die obigen Erläuterungen verwiesen.

Der Unterschied zwischen der zweiten und der dritten Ausführungsform besteht im wesentlichen darin, daß bei der dritten Ausführungsform als Leiterelement eine starre Leiterplatte 54 verwendet wird. Diese ist in gleicher Weise wie die flexible Leiterfolie mittels Positioniernasen 46 am Trägerkörper 10 präzise positioniert. Im Unterschied zur ersten und zur zweiten Ausführungsform erstrecken sich die Anschlußkontakte 20 bei der dritten Ausführungsform nicht schräg zur Oberfläche der Leiterplatte 5, sondern senkrecht zu dieser; die als Leiterelement dienende Leiterplatte 54 im Trägerkörper 10 ist als ebenes Bauteil ausgeführt.

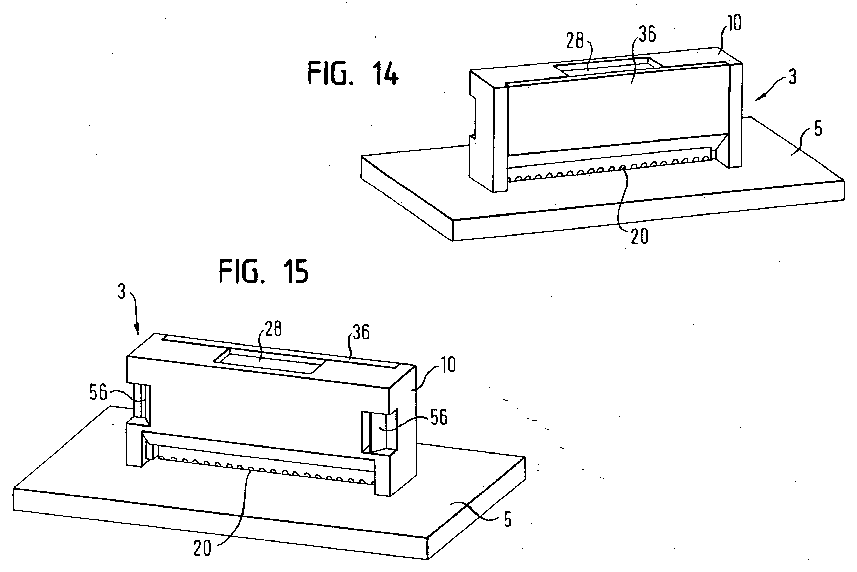

Wie in Figur 15 zu sehen ist, ist die Abdeckung 36 bei der dritten Ausführungsform mit zwei Rasthaken 56 versehen, die durch entsprechende Aussparungen im Trägerkörper 10 hindurchgreifen und auf der Rückseite einrasten. Auf diese Weise ist die Abdeckung 36 zuverlässig montiert.

Der Laserchip 22 wird bei der Montage auf seinem Leiterelement, also entweder auf dem Leadframe 12 oder auf der flexiblen Leiterfolie 44 oder auf der starren Leiterplatte 54, bezogen auf den Trägerkörper 10 positioniert. Somit ergibt sich eine unmittelbare Toleranzkette von der Leiterplatte 5 über die Positionierstifte 42 des Trägerkörpers 10 hin zum Laserchip 22. Dies ermöglicht, die Abstrahlrichtung des Laserchips 22 mit einer Genauigkeit von ±0,5° bezogen auf eine Senkrechte zur Leiterplatte 5 einzuhalten. Insgesamt ergibt sich eine Positionsgenauigkeit von 50 µm.

## Patentansprüche

1. Lasermodul mit einem Trägerkörper (10), der auf einer Leiterplatte (5) montiert werden kann, einer transparenten Scheibe (28), die in dem Trägerkörper (10) aufgenommen ist, einem Laserchip (22), der in dem Trägerkörper (10) so angebracht ist, daß seine Austrittsfläche der Scheibe (28) zugewandt ist, einem Leiterelement (12, 44, 54), das zum Kontaktieren des Laserchips dient und selbst Anschlußkontakte (20) aufweist, die mit Leiterbahnen der Leiterplatte (5) verbunden werden können, und einer Vergußmasse (34), die den Raum zwischen der Scheibe (28) und der Austrittsfläche des Laserchips (22) ausfüllt.

2. Lasermodul nach Anspruch 1, **dadurch gekennzeichnet, daß** die Scheibe (28) aus Glas oder Kunststoff besteht.

3. Lasermodul nach Anspruch 1 oder Anspruch 2, **dadurch gekennzeichnet, daß** die Scheibe (28) spielfrei in einem Rahmen (26) aufgenommen ist, der in dem Trägerkörper (10) gebildet ist.

4. Lasermodul nach Anspruch 3, **dadurch gekennzeichnet, daß** der Rahmen (26) eine durchgehende Anlagefläche (30) auf einer Seite der Scheibe (28) und mehrere Andruckvorsprünge (32) auf der anderen Seite der Scheibe (28) aufweist.

5. Lasermodul nach einem der vorhergehenden Ansprüche, **dadurch gekennzeichnet, daß** die Vergußmasse (34) aus Silikon besteht.

6. Lasermodul nach einem der vorhergehenden Ansprüche, **dadurch gekennzeichnet, daß** die Vergußmasse (34) an der Scheibe (28) festklebt.

7. Lasermodul nach einem der vorhergehenden Ansprüche, **dadurch gekennzeichnet, daß** die Vergußmasse (34) eine solche Elastizität und innere Dämpfung hat, daß eventuelle Vibrationen der Scheibe (28) nicht auf den Laserchip (22) übertragen werden.

8. Lasermodul nach einem der vorhergehenden Ansprüche, **dadurch gekennzeichnet, daß** die Dicke der Vergußmasse (34) von der Scheibe (28) zu den Anschlußkontakten (20) hin abnimmt.

9. Lasermodul nach einem der vorhergehenden Ansprüche, **dadurch gekennzeichnet, daß** der Trägerkörper (10) mit mindestens einem Positionierstift (42) versehen ist, der mit einer Positionieröffnung in der Leiterplatte (5) zusammenwirken kann.

10. Lasermodul nach einem der vorhergehenden Ansprüche, **dadurch gekennzeichnet, daß** das Leiterelement ein Leadframe (12) ist, daß der Trägerkörper (10) aus Kunststoff besteht und der Leadframe (12) in den Trägerkörper (10) präzise positioniert eingespritzt ist.

11. Lasermodul nach einem der Ansprüche 1 bis 9, **dadurch gekennzeichnet, daß** das Leiterelement eine flexible Leiterfolie (44) ist, die im Trägerkörper (10) präzise positioniert ist.

12. Lasermodul nach einem der Ansprüche 1 bis 9, **dadurch gekennzeichnet, daß** das Leiterelement eine Leiterplatte (54) ist, die im Trägerkörper (10) präzise positioniert ist.

13. Lasermodul nach Anspruch 11 oder Anspruch 12, **dadurch gekennzeichnet, daß** das Leiterelement Positionieraussparungen (48) aufweist, die mit Positioniernasen (46) zusammenwirken, die am Trägerkörper (10) ausgebildet sind.

14. Lasermodul nach einem der vorhergehenden Ansprüche, **dadurch gekennzeichnet, daß** die Anschlußkontakte (20) des Leiterelements (12, 44, 54) schräg zur Oberfläche der Leiterplatte (5) ausgerichtet sind, auf welcher der Trägerkörper (10) montiert werden kann.

15. Lasermodul nach einem der vorhergehenden Ansprüche, **dadurch gekennzeichnet, daß** der Laserchip (22) auf dem Leiterelement (12, 44, 54) angeordnet ist, so daß das Leiterelement als Kühlkörper wirkt.

16. Lasermodul nach einem der vorhergehenden Ansprüche, **dadurch gekennzeichnet, daß** eine Abdeckung (36) vorgesehen ist, die auf dem Trägerkörper (10) einrastet und die Seite des Trägerkörpers (10) abdeckt, auf welcher der Laserchip (22) angebracht ist.
